# EUROPÄISCHE PATENTANMELDUNG

(11) **EP 0 525 517 A1**
(43) Veröffentlichungstag der Anmeldung: **03.02.1993**
(21) Anmeldenummer: 92112089.5
(22) Anmeldetag: 15.07.1992
(51) Int. Cl.: H01L 21/90, H01L 21/285, H01L 29/40, H01L 23/485

(54) **Verfahren zur Auffüllung mindestens eines Kontaktloches in einer isolierenden Schicht**

(30) Priorität: 02.08.1991 DE 4125740
(71) Anmelder: SIEMENS AKTIENGESELLSCHAFT, D-80333 München (DE)
(72) Erfinder: Willer, Josef, Dr., W-8012 Riemerling (DE); Wendt, Hermann, Dr., W-8011 Neukeferloh (DE)

(57) **Zusammenfassung**

Zum Auffüllen eines Kontaktloches (3) mit einer aluminiumhaltigen Kontaktschicht (7) wird in dem mit einer Haftschicht (4) und einer Diffusionsbarriereschicht (5) versehenen Kontaktloch (3) vor der Abscheidung der Kontaktschicht (7) eine Zwischenschicht (6) erzeugt. Die Zwischenschicht (6) besteht aus Hafnium, das mit Aluminium eine intermetallische Phase ausbildet. Die Kontaktschicht (7) wird bei mindestens 300 ° C durch Sputtern abgeschieden.

## Beschreibung

In der Mikroelektronik werden in einem Substrat integrierte Schaltelemente mit isolierenden Schichten bedeckt. Zur Kontaktierung einzelner Schaltelemente werden in den isolierenden Schichten Kontaktlöcher erzeugt und mit leitfähigem Material aufgefüllt. Um dabei einen guten Kontaktwiderstand zu erzielen, ist eine möglichst vollständige Auffüllung des Kontaktloches erforderlich.

In komplexen integrierten Schaltungen sind im allgemeinen mehr als zwei Metallisierungsebenen vorgesehen. Benachbarte Metallsierungsebenen sind dabei gegeneinander durch isolierende Schichten getrennt. Elektrische Verbindungen zwischen benachbarten Metallisierungsebenen erfolgen durch mit leitfähigem Material aufgefüllte Kontaktlöcher, die in diesem Fall Viaholes genannt werden. Auch hier ist es für einen guten Kontaktwiderstand wichtig, daß jedes Kontaktloch möglichst vollständig aufgefüllt ist.

Mit zunehmender Miniaturisierung und abnehmender Kontaktlochweite wird eine Verschlechterung der Auffüllung des Kontaktloches beobachtet.

Es ist bekannt, Kontaktlöcher durch Sputtern von Aluminium aufzufüllen. Um dabei eine verbesserte Kantenbedeckung zu erzielen, werden Kontaktlöcher mit abgeschrägten Flanken erzeugt. Dies führt jedoch zu einem vergrößerten Platzbedarf.

Eine weitere Möglichkeit besteht in der Auffüllung von Kontaktlöchern mit konform aus der Gasphase abgeschiedenen Wolframschichten. Dadurch wird eine vollständige Auffüllung ermöglicht. Ein Nachteil dieser Technologie besteht darin, daß der Abscheideschritt aufwendig ist. Des weiteren erfordert diese Technologie anschließend einen Rückätzschritt, der ebenfalls aufwendig und teuer ist.

Es ist bekannt, bei der Auffüllung eines Kontaktloches durch Sputtern von Aluminium an das Substrat eine Gegenspannung anzulegen (s. Hariu, T., et al., Proc. Int. Reliability Phys. Symp. (1989) S. 210). Dadurch wird zwar eine verbesserte Auffüllung erreicht, gleichzeitig verschlechtert sich jedoch das Elektromigrationsverhalten. In Hariu, T., et al., Proc. Int. Reliability Phys. Symp. (1989) S. 210 wird weiterhin berichtet, daß das Aufbringen einer Titanschicht vor dem Sputtern des Aluminiums vorteilhaft ist.

Aus Lin, T. et al., Proc. fifth Int. IEEE VLSI Multilevel Interconnection Conf. (1988) S. 76 ist bekannt, daß eine titanhaltige Unterlage unter einer Aluminiumschicht in einem Kontaktloch die Auffüllung des Kontaktloches unterstützt.

Die Titanschichten werden in der Literatur durch Sputtern aufgebracht. In Sputteranlagen ist stets ein Trägergas vorhanden, das durch Aufprall auf ein Target das zu sputternde Material aus dem Target herauslöst. Das zu sputternde Material wird dann auf ein Substrat gelenkt. Dabei kommt es vor dem Substrat zu Stößen zwischen dem zu sputternden Material und Trägergasatomen. Es ist allgemein bekannt, daß bei Stößen zwischen Teilchen gleicher Masse ein großer Impulsübertrag auftritt, während bei Stößen zwischen Teilchen stark unterschiedlicher Masse auf das schwerere Teilchen praktisch kein Impuls übertragen wird. Da in Sputteranlagen im allgemeinen Argon als Trägergas verwendet wird, das die Massenzahl 40 hat, und da Titan sich davon mit seiner Massenzahl 48 nur wenig unterscheidet, kommt es beim Sputtern von Titan zu großen Streuungen. Dieses hat zur Folge, daß bei der Abscheidung einer Titanschicht in einem Kontaktloch die sich ergebende Schichtdicke auf der isolierenden Schicht viel größer ist als in dem Kontaktloch, da die Kontaktlochkanten auf schräg einfallende Titanatome abschattend wirken. Um eine ausreichende Schichtdicke im Kontaktloch zu erhalten, muß die Titanschicht daher außerhalb des Kontaktloches in einer wesentlich größeren Dicke abgeschieden werden. Dieses Problem wird mit zunehmender Miniaturisierung und abnehmender Kontaktlochweite immer größer.

Der Erfindung liegt das Problem zugrunde, ein Verfahren zur Auffüllung eines Kontaktloches in einer isolierenden Schicht anzugeben, bei dem eine vollständige Auffüllung des Kontaktloches gewährleistet ist und bei dem die zusätzliche Abscheidung unverhältnismäßig dicker Schichten vermieden wird.

Das Problem wird erfindungsgemäß gelöst in einem Verfahren nach Anspruch 1.

Die Erfindung macht sich die Erkenntnis zunutze, daß bei einem Sputtern von Aluminium auf eine isolierende Schicht, die ein Kontaktloch aufweist, eine Benetzung der Unterlage im Kontaktloch wegen der hohen Oberflächenspannung des Aluminiums bei erhöhter Abscheidetemperaturen oberhalb 300 ° C im allgemeinen nicht stattfindet. Durch Abscheidung einer Zwischenschicht in dem Kontaktloch, die aus Hafnium besteht, das mit dem Aluminium in dem Temperaturbereich zwischen 300 ° C und 400 C, in dem das Aluminium gesputtert wird, eine intermetallische Phase ausbildet, wird für eine Benetzung des Aluminiums im Kontaktloch gesorgt.

Die aus der Literatur bekannte, vorteilhafte Wirkung des Titans bei der Auffüllung von Kontaktlöchern mit Aluminium beruht ebenfalls auf diesem Effekt.

Da in dem erfindungsgemäßen Verfahren die Zwischenschicht aus Hafnium mit dem Atomgewicht 178, 49 gebildet wird, ist die im Kontaktloch erreichbare relative Schichtdicke erheblich größer als bei Titan. Durch den großen Unterschied in der Massenzahl wird bei Stößen zwischen Hafnium und Argon praktisch kein Impuls auf Hafnium übertragen. Daher wird Hafnium beim Sputtern kaum seitlich gestreut.

Es ist besonders vorteilhaft, nach der Abscheidung der Zwischenschicht das Substrat mit der darauf befindlichen Schichtenfolge im Ultrahochvakuum in eine Reaktionskammer zu transferieren, in der die Kontaktschicht aufgebracht wird. Dadurch wird während des Transfers eine Oxidbildung auf der Zwischenschicht verhindert. Ist der Sauerstoffpartialdruck zu hoch, so können sich in der Zwischenschicht Oxidinseln bilden, die zur Verzögerung der Reaktion zur Ausbildung der intermetallischen Phase führen. Es ist vorteilhaft, den Transfer in einem sehr guten Vakuum im 10-⁸ hPa-Bereich durchzuführen.

Weitere Ausgestaltungen der Erfindung gehen aus den übrigen Ansprüchen hervor.

Im folgenden wird die Erfindung anhand eines Ausführungsbeispiels und der Figuren näher erläutert.
Fig. 1 zeigt ein Substrat, auf dem eine isolierende Schicht mit einem Kontaktloch angeordnet ist.
Fig. 2 zeigt das mit Aluminium aufgefüllte Kontaktloch.

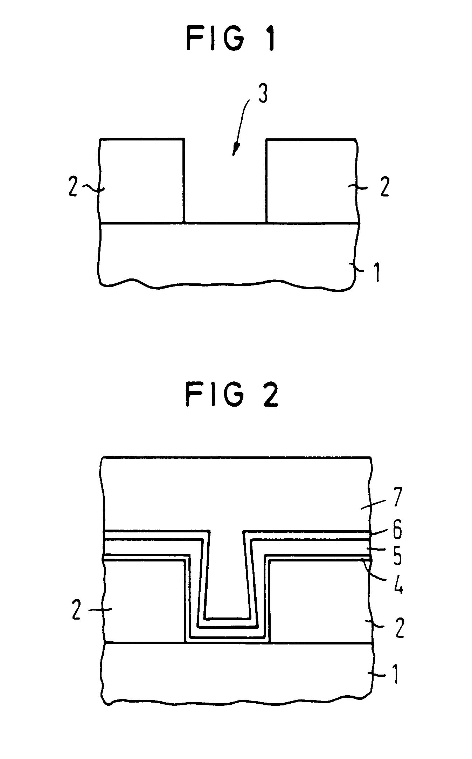

Ein Substrat 1 aus z. B. einkristallinem Silizium, das verschiedene Schaltelemente enthält (nicht dargestellt), ist mit einer isolierenden Schicht 2 versehen (s. Fig. 1). Die isolierende Schicht 2 besteht z. B. aus Si0₂. In der isolierenden Schicht 2 ist ein Kontaktloch 3 durch Ätzen erzeugt. In dem Kontaktloch 3 ist die Oberfläche des Siliziumsubstrats 1 freigelegt. Das Kontaktloch 3 hat z. B. einen Durchmesser von 0,7 um und eine Tiefe von 1,1 um. Die Wände des Kontaktloches 3 sind senkrecht.

Die isolierende Schicht 2 weist neben dem dargestellten Kontaktloch 3 eine Vielzahl weiterer Kontaktlöcher auf. Diese sind jedoch übersichtlichkeitshalber nicht dargestellt. Sie werden in dem erfindungsgemäßen Verfahren gleichzeitig mit dem Kontaktloch 3 aufgefüllt.

Auf die isolierende Schicht 2 wird durch Sputtern (Kathoden zerstäuben) eine Haftschicht 4 aufgebracht (s. Fig. 2). Die Haftschicht 4 bedeckt die Oberfläche der isolierenden Schicht 2 und die freiliegende Oberfläche des Siliziumsubstrats 1 im Bereich des Kontaktloches 3 sowie die das Kontaktloch 3 seitlich begrenzenden Flanken der isolierenden Schicht 2 vollständig. Die Haftschicht 4 wird z. B. aus Titan in einer Dicke von 30 nm aufgestäubt.

Auf der Haftschicht 4 wird eine Diffusionsbarriereschicht 5 durch Sputtern abgeschieden. Die Diffusionsbarriereschicht 5 wird z. B. aus TiN in einer Dicke von 150 nm aufgestäubt.

Auf die Diffusionsbarriereschicht 5 wird eine Zwischenschicht 6 durch Sputtern aufgebracht. Die Zwischenschicht 6 besteht aus Hafnium , das ein Atomgewicht von 178, 49 hat und das mit Aluminium eine intermetallische Phase ausbildet. Die Zwischenschicht 6 wird in einer Dicke von z. B. 20 nm aufgestäubt. An der dünnsten Stelle der Zwischenschicht 6 ist eine Schichtdicke von z. B. 10 nm ausreichend.

Anschließend wird das Substrat 1 mit der isolierenden Schicht 2, der Haftschicht 4, der Diffusionsbarriereschicht 5 und der Zwischenschicht 6 in eine Abscheidungskammer transferiert, in dem eine Kontaktschicht 7 hergestellt wird. Die Kontaktschicht 7 besteht aus Aluminium mit Beimengungen von Silizium und Kupfer. Die Kontaktschicht 7 wird durch Sputtern im Temperaturbereich zwischen 400 ° C und 580 ° C erzeugt. Bei dieser Temperatur haben die Aluminiumatome eine genügend hohe Beweglichkeit, so daß sie von der Zwischenschicht 6 in den Bereich des Kontaktloches 3 gesogen werden. Zwischen der Zwischenschicht 6 und den Aluminiumatomen findet die Reaktion zu der intermetallischen Phase statt. Dabei wird Bildungswärme frei, die diesen Vorgang weiter fördert. Auf diese Weise kommt es zu einer vollständigen Auffüllung des Kontaktloches bei einer gleichzeitig im wesentlichen planaren Oberfläche der Kontaktschicht 7.

Das erfindungsgemäße Verfahren ist ebenfalls geeignet zur Auffüllung von Kontaktlöchern zwischen übereinander angeordneten Metallisierungsebenen in integrierten Schaltungen, sogenannten Viaholes.

Das Problem der Kontaktlochauffüllung in isolierenden Schichten tritt unabhängig von dem Material des darunter angeordneten Substrats auf. Das erfindungsgemäße Verfahren löst dieses Problem unabhängig vom Material des darunter angeordneten Substrats. Es ist daher auch auf Substrate aus anderen Halbleitern, z. B. III-V-Halbleitern oder Germanium, aus amorphem oder polykristallinem Material, wie z. B. amorphes Silizium oder Glas, anwendbar.

## Patentansprüche

1. Verfahren zur Auffüllung mindestens eines Kontaktloches in einer isolierenden Schicht,
- bei dem auf die isolierende Schicht (2), die auf einem Substrat (1) angeordnet ist, eine Schichtfolge bestehend aus einer Haftschicht (4) und einer Diffusionsbarriereschicht (5) abgeschieden wird,
- bei dem auf die Diffusionsbarriereschicht (5) durch Sputtern eine Zwischenschicht (6) aus Hafnium abgeschieden wird,
- bei dem auf die Zwischenschicht (6) bei einer Temperatur über 300 ° C eine aluminiumenthaltende Kontaktschicht (7) durch Sputtern in einer solchen Dicke aufgebracht wird, daß sie das Kontaktloch (3) vollständig ausfüllt.

2. Verfahren nach Anspruch 1,
bei dem das Substrat (1) nach der Abscheidung der Zwischenschicht (6) unter Hochvakuum in eine Abscheidekammer, in der die Kontaktschicht (7) aufgebracht wird, transferiert wird.

3. Verfahren nach Anspruch 1 oder 2,
bei dem die Kontaktschicht im Temperaturbereich zwischen 400 ° C und 580 ° C erzeugt wird.

4. Verfahren nach einem der Ansprüche 1 bis 3, bei dem die Kontaktschicht (7) Beimengungen mindestens eines der Elemente Cu und Si enthält.

5. Verfahren nach einem der Ansprüche 1 bis 4, bei dem die Haftschicht (4) aus Titan besteht.

6. Verfahren nach einem der Ansprüche 1 bis 5, bei dem die Diffusionsbarriereschicht (5) aus TiN besteht.

7. Verfahren nach einem der Ansprüche 1 bis 6, bei dem das Substrat (1) aus Silizium besteht.
